# EUROPEAN PATENT APPLICATION

(11) **EP 4 628 543 A1**
(43) Date of publication of application: **08.10.2025**
(21) Application number: 23905622.9
(22) Date of filing: 27.11.2023
(51) Int. Cl.: C08L 77/06, C08L 77/02, C08K 5/52, C08K 3/24, C08K 3/22, C08K 9/10, C08K 3/32, C08K 5/5313, C08K 13/06, H05K 5/00

(54) **FLAME-RETARDANT POLYAMIDE COMPOSITE MATERIAL, AND PREPARATION METHOD THEREFOR AND USE THEREOF**

(30) Priority: 19.12.2022 CN 202211632599
(71) Applicant: KINGFA SCI. & TECH. CO., LTD., Guangzhou, Guangdong 510663 (CN)
(72) Inventor: ZHENG, Yiquan, Guangzhou, Guangdong 510663 (CN); CHEN, Pingxu, Guangzhou, Guangdong 510663 (CN); YE, Nanbiao, Guangzhou, Guangdong 510663 (CN); WANG, Feng, Guangzhou, Guangdong 510663 (CN); DING, Chao, Guangzhou, Guangdong 510663 (CN); JIN, Xuefeng, Guangzhou, Guangdong 510663 (CN); ZHANG, Xianjun, Guangzhou, Guangdong 510663 (CN); LIU, Xinxin, Guangzhou, Guangdong 510663 (CN)
(74) Representative: Meyer, Thorsten
(86) International application number: PCT/CN2023/134414
(87) International publication number: WO 2024/131454

(57) **Abstract**

Provided is a flame-retardant polyamide composite material, including the following components in parts by weight: 50 parts of a polyamide resin, 10 parts to 35 parts of a phosphorus-containing halogen-free flame retardant, 0.1 part to 20 parts of melamine-formaldehyde resin-coated melamine polyphosphate (MPP), and zirconium, where MPP in the melamine-formaldehyde resin-coated MPP is complexed with the zirconium, and a weight content of the zirconium is 100 ppm to 5,000 ppm based on a total weight of the melamine-formaldehyde resin-coated MPP. In the flame-retardant polyamide composite material of this disclosure, an MPP flame retardant is complexed with zirconium and coated with a melamine-formaldehyde resin, which can effectively improve the precipitation stability (reducing mold deposits) during processing and the color stability during a dual 85 test for the colored polyamide material.

## Description

### TECHNICAL FIELD

The present disclosure relates to the technical field of polymer materials, and in particular relates to a flame-retardant polyamide composite material and a preparation method and use thereof.

### BACKGROUND

Nylon is widely used in electronics, electrical engineering, and other industries due to advantages such as excellent electrical properties and low cost. Because the nylon resin has a relatively high melting point, there are currently few high-temperature-resistant flame retardants available. Melamine polyphosphate (MPP) is a highly effective flame retardant for nylon. Due to the susceptibility of MPP to shearing, melamine and polyphosphate are released during the processing, resulting in the generation of large quantities of mold deposits on the surface of a mold during injection molding, which affects the processing stability of nylon and makes a molded part prone to scorching and flow marks during injection molding.

The coating modification of MPP with a resin (as described in the patents CN1047690291A and CN110607066A) can mitigate the generation of mold deposits during processing. However, there are still problems such as precipitation caused by a 85°C/85% humidity treatment (dual 85 test) and easy discoloration after injection molding.

### SUMMARY

An objective of the present disclosure is to address the aforementioned technical defects and provide a colored polyamide material that exhibits improved precipitation stability during processing and enhanced color stability during a dual 85 test.

The present disclosure is implemented by the following technical solutions:

The present disclosure provides a flame-retardant polyamide composite material, including the following components in parts by weight: 50 parts of a polyamide resin, 10 parts to 35 parts of a phosphorus-containing halogen-free flame retardant, 0.1 part to 20 parts of melamine-formaldehyde resin-coated MPP, and zirconium, where MPP in the melamine-formaldehyde resin-coated MPP is complexed with the zirconium, and a weight content of the zirconium is 100 ppm to 5,000 ppm based on a total weight of the melamine-formaldehyde resin-coated MPP.

Preferably, the weight content of the zirconium is 1,000 ppm to 3,000 ppm based on the total weight of the melamine-formaldehyde resin-coated MPP.

Preferably, in the melamine-formaldehyde resin-coated MPP, a weight percent of a melamine-formaldehyde resin is 0.2 wt% to 4 wt%. Optionally, in the present disclosure, the weight percent of the melamine-formaldehyde resin may be 0.2 wt%, 0.4 wt%, 0.8 wt%, 1 wt%, 1.2 wt%, 1.4 wt%, 1.8 wt%, 2 wt%, 2.2 wt%, 2.4 wt%, 2.8 wt%, 3 wt%, 3.2 wt%, 3.4 wt%, 3.8 wt%, 4 wt%, etc.

The zirconium is derived from at least one selected from the group consisting of metazirconic acid and zirconium dichloride oxide (also known as zirconyl chloride, or Zirconium(IV) oxide chloride).

In the flame-retardant polyamide composite material of the present disclosure, an MPP flame retardant is complexed with zirconium at a content of 100 ppm to 5,000 ppm and coated with melamine-formaldehyde resin, which can effectively improve the precipitation stability (reducing mold deposits) during processing and the color stability during a dual 85 test for the colored polyamide material. The present disclosure has no special restriction on a method for coating the MPP with the melamine-formaldehyde resin and complexing the MPP with zirconium. In some embodiments, the method can be as follows:
adding water and ethanol, and heating; adding a melamine-formaldehyde prepolymer and an emulsifier, and stirring; adding MPP and a zirconium-containing compound, and further stirring; adjusting a pH to 4 to 5, heating to 80°C to 90°C, and allowing a reaction under stirring; and filtering to produce a filter residue, which is MPP complexed with zirconium and coated with a melamine-formaldehyde resin.

Specifically, the method for preparing the MPP complexed with zirconium and coated with a melamine-formaldehyde resin can be as follows: adding deionized water (at an amount 3 times to 10 times a weight of MPP) and ethanol (at an amount 0.5 time to 3 times the weight of MPP) to a container, and heating to 60°C to 80°C; adding a melamine-formaldehyde prepolymer and an emulsifier, and stirring at a high speed for 1 min to 60 min; adding MPP and metazirconic acid (or zirconium dichloride oxide), and stirring at a high speed for 0.5 h to 5 h; adjusting a pH with acetic acid to 4 to 5, raising a temperature to 80°C to 90°C, and stirring for 1 h to 5 h; and filtering to produce a filter residue, which is the MPP complexed with zirconium and coated with a melamine-formaldehyde resin.

By the above method, MPP can be complexed with zirconium and coated with a melamine-formaldehyde prepolymer.

A zirconium content in the MPP complexed with zirconium and coated with a melamine-formaldehyde resin is analyzed by inductively coupled plasma (ICP) elemental analysis for zirconium.

The phosphorus-containing halogen-free flame retardant is at least one selected from the group consisting of aluminum hypophosphite, aluminum diethylphosphinate, zinc diethylphosphinate, aluminum methyl-ethylphosphinate, and zinc methyl-ethylphosphinate.

The polyamide is at least one selected from the group consisting of an aliphatic polyamide and a semi-aromatic polyamide; the aliphatic polyamide is at least one selected from the group consisting of PA6 (poly (ε-caprolactam), also known as polycaprolactam), PA66 (polyhexamethylene adipamide), and PA610 (polyhexamethylene sebacamide); and the semi-aromatic polyamide is at least one selected from the group consisting of PA10T (poly (decamethylene terephthalamide)), PA6T (poly(hexamethylene terephthalamide)), and PA6I/6T (poly(hexamethylene isophthalamide-co-terephthalamide)).

The flame-retardant polyamide composite material further includes the following component in part by weight: 0 part to 30 parts of a glass fiber.

The present disclosure provides a preparation method of the flame-retardant polyamide composite material, including the following steps: thoroughly mixing the components according to the parts by weight, and conducting extrusion-granulation by a twin-screw extruder with a screw temperature of 250°C to 280°C and a rotational speed of 200 rpm to 500 rpm to produce the flame-retardant polyamide composite material.

The present disclosure provides a use of the flame-retardant polyamide composite material in a housing for an electronic and electrical device, such as a connector, a contactor, and a circuit breaker.

The present disclosure has the following beneficial effects:

In the flame-retardant polyamide composite material of the present disclosure, MPP is complexed with zirconium and coated with a melamine-formaldehyde resin, which can effectively improve the precipitation stability (reducing mold deposits) during processing and the color stability during a dual 85 test for the colored polyamide material. As a result, the service life of a mold during injection molding can be extended, and the cleaning frequency for a mold can be reduced.

### BRIEF DESCRIPTION OF THE DRAWING

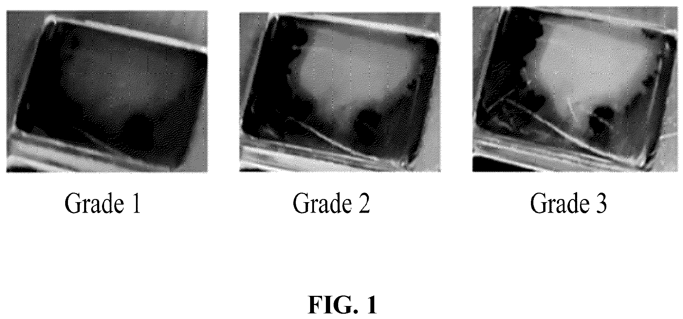

FIG. 1 shows the standard references for mold deposit evaluation.

### DETAILED DESCRIPTION

The present disclosure is described in detail below with reference to specific embodiments. The following embodiments will help those skilled in the art to further understand the present disclosure, but do not limit the present disclosure in any way. It should be noted that those of ordinary skill in the art can further make several variations and improvements without departing from the idea of the present disclosure. These all fall within the protection scope of the present disclosure.

Sources for the raw materials adopted in the present disclosure are as follows:
PA66: 50BWFS, ASCEND Company.
PA6: M2400, Xinhui Meida Nylon Co., Ltd.
PA10T: PA10T, Zhuhai Vanteque Specialty Engineering Plastics Co., Ltd.
Aluminum hypophosphite: M116, Shanghai Lidao New Material Technology Co., Ltd.
Aluminum diethylphosphinate: OP1230, Clariant.

A preparation method of coated MPP was as follows: deionized water (at an amount 3 times to 10 times a weight of MPP) and ethanol (at an amount 0.5 time to 3 times the weight of MPP) were added to a container, and heated to 60°C to 80°C. A melamine-formaldehyde prepolymer and an emulsifier were added, and high-speed stirring was conducted for 1 min to 60 min. MPP and metazirconic acid (or zirconium dichloride oxide) (in the preparation method of coated MPP-J, a zirconium-containing compound was not added) were added, and high-speed stirring was conducted for 0.5 h to 5 h. A pH was adjusted with acetic acid to 4 to 5, a temperature was raised to 80°C to 90°C, and stirring was conducted for 1 h to 5 h. Filtration was conducted to produce MPP complexed with zirconium and coated with a melamine-formaldehyde resin.

Coated MPP-A: zirconium content: 116 ppm, melamine-formaldehyde resin content: 0.8 wt%, homemade.

Coated MPP-B: zirconium content: 1,021 ppm, melamine-formaldehyde resin content: 0.8 wt%, homemade.

Coated MPP-C: zirconium content: 1,440 ppm, melamine-formaldehyde resin content: 0.2 wt%, homemade.

Coated MPP-D: zirconium content: 2,006 ppm, melamine-formaldehyde resin content: 2 wt%, homemade.

Coated MPP-E: zirconium content: 2,533 ppm, melamine-formaldehyde resin content: 4 wt%, homemade.

Coated MPP-F: zirconium content: 2,989 ppm, melamine-formaldehyde resin content: 0.8 wt%, homemade.

Coated MPP-G: zirconium content: 4,802 ppm, melamine-formaldehyde resin content: 0.8 wt%, homemade.

Coated MPP-H: zirconium content: 1,497 ppm, melamine-formaldehyde resin content: 0.1 wt%, homemade.

Coated MPP-I: zirconium content: 1,505 ppm, melamine-formaldehyde resin content: 4.5 wt%, homemade.

MPP: Melapur^{®} 200, BASF.

Coated MPP-J: melamine-formaldehyde resin content: 0.8 wt%, zirconium-free, homemade.

Glass fiber: ECS11-4.5-560A, Jushi Group Co., Ltd.

In examples and comparative examples, a preparation method of a flame-retardant polyamide composite material was as follows: components were thoroughly mixed according to parts by weight, and then subjected to extrusion-granulation by a twin-screw extruder with a screw temperature of 250°C to 280°C and a rotational speed of 300 rpm to produce the flame-retardant polyamide composite material.

Test methods were as follows:
(1) Flame retardancy: The flame retardancy was tested according to the UL94-2021 standard with a thickness of 2.5 mm.
(2) Mold deposits: A KraussMaffei instrument (model: CX 160-750) was adopted. An injection molding process was as follows: a material temperature was 280°C, a medium to high injection speed was adopted, and 300 cycles of injection molding were conducted continuously. Mold deposits were visually assessed, as shown in FIG. 1. Visual grading for mold deposits: Grade 1: there is a sparse accumulation of mold deposits, and an underlying surface can be clearly seen through mold deposits at a mold deposits collection site. Grade 2: There is a moderate accumulation of mold deposits, and an underlying surface can be vaguely seen through mold deposits at a mold deposits collection site. Grade 3: There is a dense accumulation of mold deposits, and an underlying surface cannot be seen at all through mold deposits at a mold deposits collection site.
(3) Color stability ΔE during a dual 85 test: A dumbbell-shaped sample was injection-molded according to the standard ISO 527-2 and placed at a temperature of 85°C and a humidity of 85% for 336 h. Changes in LAB values were measured by an X-Rite differential colorimeter.

**Table 1 Component contents (in parts by weight) and test results of the flame-retardant polyamide composite materials in Examples 1 to 8**

| | Example 1 | Example 2 | Example 3 | Example 4 | Example 5 | Example 6 | Example 7 | Example 8 |
|---|---|---|---|---|---|---|---|---|
| PA66 | 50 | | | 50 | 50 | 50 | 50 | |
| PA6 | | 50 | | | | | | 50 |
| PA10T | | | 50 | | | | | |
| OP1230 | 16 | 16 | 16 | 10 | 24 | 35 | 16 | |
| Aluminum hypophosphite | | | | | | | | 12 |
| Type of coated MPP | A | A | A | A | A | A | B | A |
| Content of coated MPP | 3 | 3 | 3 | 20 | 10 | 0.1 | 3 | 5 |
| Glass fiber | - | 25 | - | - | - | - | - | - |
| Flame retardancy grade | V-1 | V-0 | V-1 | V-2 | V-0 | V-0 | V-1 | V-0 |
| Mold deposits grade | 1 | 1 | 1 | 1 | 1 | 1 | 1 | 1 |
| ΔE | 8.3 | 5.6 | 5.1 | 12.3 | 10.7 | 9.8 | 5.2 | 4.9 |

It can be seen from Examples 1 to 6 that, within the scopes of the present disclosure, the advantages, such as flame retardancy of V-2 or higher, minimal generation of mold deposits, and excellent color stability during a dual 85 test, can be achieved.

**Table 2 Component contents (in parts by weight) and test results of the flame-retardant polyamide composite materials in Examples 9 to 15**

| | Example 9 | Example 10 | Example 11 | Example 12 | Example 13 | Example 14 | Example 15 |
|---|---|---|---|---|---|---|---|
| PA66 | 50 | 50 | 50 | 50 | 50 | 50 | 50 |
| OP1230 | 16 | 16 | 16 | 16 | 16 | 16 | 16 |
| Type of coated MPP | C | D | E | F | G | H | I |
| Content of coated MPP | 3 | 3 | 3 | 3 | 3 | 3 | 3 |
| Flame retardancy grade | V-1 | V-1 | V-1 | V-1 | V-1 | V-1 | V-1 |
| Mold deposits grade | 1 | 1 | 1 | 1 | 1 | 2 | 2 |
| ΔE | 4.2 | 4.6 | 3.1 | 4.9 | 5.3 | 7.5 | 6.3 |

It can be seen from Examples 1 and 8 to 15 that, preferably, when the zirconium content is 1,000 ppm to 3,000 ppm, there is superior color stability during the dual 85 test, and preferably, when the weight percent of the melamine-formaldehyde resin is 0.2 wt% to 4 wt%, there is a small accumulation of mold deposits.

**Table 3 Component contents (in parts by weight) and test results of the flame-retardant polyamide composite materials in comparative examples**

| | Comparative Example 1 | Comparative Example 2 | Comparative Example 3 |
|---|---|---|---|
| PA66 | 50 | 50 | 50 |
| OP1230 | 16 | 16 | 19 |
| MPP | 3 | | |
| Type of coated MPP | | J | |
| Content of coated MPP | | 3 | |
| Flame retardancy | V-1 | V-1 | NR |
| Mold deposits | 3 | 2 | 3 |
| ΔE | 25.5 | 16.9 | 19.2 |

It can be seen from Comparative Example 1 that, when the conventional uncoated MPP is adopted, mold deposits are generated in large amounts, and there is poor color stability during the dual 85 test.

According to Comparative Example 2, the coated MPP-J (that is free of zirconium and has a melamine-formaldehyde resin content of 0.8 wt%) causes severe mold deposits and poor color stability during the dual 85 test.

## Claims

1. A flame-retardant polyamide composite material, comprising the following components in parts by weight: 50 parts of a polyamide resin, 10 parts to 35 parts of a phosphorus-containing halogen-free flame retardant, 0.1 part to 20 parts of melamine-formaldehyde resin-coated melamine polyphosphate (MPP), and zirconium, wherein MPP in the melamine-formaldehyde resin-coated MPP is complexed with the zirconium, and a weight content of the zirconium is 100 ppm to 5,000 ppm based on a total weight of the melamine-formaldehyde resin-coated MPP.

2. The flame-retardant polyamide composite material according to claim 1, wherein the weight content of the zirconium is 1,000 ppm to 3,000 ppm based on the total weight of the melamine-formaldehyde resin-coated MPP.

3. The flame-retardant polyamide composite material according to claim 1, wherein in the melamine-formaldehyde resin-coated MPP, a weight percent of a melamine-formaldehyde resin is 0.2 wt% to 4 wt%.

4. The flame-retardant polyamide composite material according to claim 1, wherein the zirconium is derived from at least one selected from the group consisting of metazirconic acid and zirconium dichloride oxide.

5. The flame-retardant polyamide composite material according to claim 1, wherein the phosphorus-containing halogen-free flame retardant is at least one selected from the group consisting of aluminum hypophosphite, aluminum diethylphosphinate, zinc diethylphosphinate, aluminum methyl-ethylphosphinate, and zinc methyl-ethylphosphinate.

6. The flame-retardant polyamide composite material according to claim 1, wherein the polyamide is at least one selected from the group consisting of an aliphatic polyamide and a semi-aromatic polyamide; the aliphatic polyamide is at least one selected from the group consisting of PA6, PA66, and PA610; and the semi-aromatic polyamide is at least one selected from the group consisting of PA10T, PA6T, and PA6I/6T.

7. The flame-retardant polyamide composite material according to claim 1, further comprising the following component in part by weight: 0 part to 30 parts of a glass fiber.

8. A preparation method of the flame-retardant polyamide composite material according to any one of claims 1 to 7, comprising the following steps: thoroughly mixing the components according to the parts by weight, and conducting extrusion-granulation by a twin-screw extruder with a screw temperature of 250°C to 280°C and a rotational speed of 200 rpm to 500 rpm to produce the flame-retardant polyamide composite material.

9. A use of the flame-retardant polyamide composite material according to any one of claims 1 to 7 in a housing for an electronic and electrical device.
